# EUROPEAN PATENT APPLICATION

(11) **EP 4 017 225 A1**
(43) Date of publication of application: **22.06.2022**
(21) Application number: 20824884.9
(22) Date of filing: 06.11.2020
(51) Int. Cl.: H05K 1/18, H05K 1/02, H05K 3/28, H05K 3/30, H05K 3/46

(54) **EMBEDDED CIRCUIT BOARD AND PREPARATION METHOD THEREFOR**

(30) Priority: 07.07.2020 CN 202010645377
(71) Applicant: Shennan Circuits Co., Ltd., Shenzhen City, Guangdong 518117 (CN)
(72) Inventor: HUANG, Lixiang, Guangdong 518117 (CN); WANG, Zedong, Guangdong 518117 (CN); MIAO, Hua, Guangdong 518117 (CN)
(74) Representative: de Arpe Fernandez, Manuel
(86) International application number: PCT/CN2020/127012
(87) International publication number: WO 2022/007270

(57) **Abstract**

The present disclosure relates to circuit boards, and provides an embedded circuit board and a method for manufacturing the same. The embedded circuit board includes: a baseboard defining a recess; an electronic component disposed in the recess; and a package body covering an outer surface of the electronic component to separate the electronic component and a sidewall of the recess. The package body is made of a plastic enveloping material and the plastic enveloping material includes a base material and at least one of silicon dioxide, silicon carbide, silicon nitride and crystalline silicon powder. According to the present disclosure, the outer surface of the electronic component is covered by the package body including the plastic enveloping material. The plastic enveloping material has several characters such as good heat dissipation capacity, low thermal expansion coefficient, high-temperature resistance, good bonding ability and high reliability. Thus, if the temperature of the electronic component rises when the electronic component functions, the package body may release the heat rapidly.

## Description

### TECHNICAL FIELD

The present disclosure generally relates to circuit boards, and in particular to an embedded circuit board and a method for manufacturing the same.

### BACKGROUND

A circuit board, for example a printed circuit board (PCB), is an important electronic device. The circuit board can provide support and connection for electronic components. PCB occur almost in every kind of electronic devices.

Traditional circuit boards may suffer warping or expansion during thermal processes because of temperature changes, which may lead to fall-off and expansion deformation of electronic components of the circuit board.

### SUMMARY

Accordingly, the present disclosure aims to provide an embedded circuit board and a method for manufacturing the same. The scheme provided in the present disclosure is flexible and can be implemented in different applications.

To solve the above-mentioned problem, a technical scheme adopted by the present disclosure is to provide a method for manufacturing an embedded circuit board. The method includes: providing a baseboard defining at least one recess; disposing an electronic component in the recess, wherein an outer surface of the electronic component is arranged with a plastic enveloping material for forming a package body, the plastic enveloping material comprises a base material and an auxiliary material, the base material comprises at least one of polyimide, epoxy resin, phenolic resin, curable polymer-based material and curable resin-based material, the auxiliary material comprises at least one of silicon dioxide, silicon carbide, silicon nitride and crystalline silicon powder; and laminating the baseboard to form the package body after the plastic enveloping material is melted, wherein the package body covers the outer surface of the electronic component, and the package body separates the electronic component and a sidewall of the recess.

To solve the above-mentioned problem, a technical scheme adopted by the present disclosure is to provide an embedded circuit board. The embedded circuit board includes: a baseboard defining a recess; an electronic component disposed in the recess; and a package body covering an outer surface of the electronic component to separate the electronic component and a sidewall of the recess, wherein the package body is made of a plastic enveloping material and the plastic enveloping material comprises a base material and at least one of silicon dioxide, silicon carbide, silicon nitride and crystalline silicon powder.

To solve the above-mentioned problem, a technical scheme adopted by the present disclosure is to provide a method for manufacturing an embedded circuit board. The method includes: providing a baseboard defining at least one recess; disposing an electronic component in the recess, wherein an outer surface of the electronic component is arranged with a plastic enveloping material for forming a package body, the plastic enveloping material comprises a base material and at least one of silicon dioxide, silicon carbide, silicon nitride and crystalline silicon powder; and laminating the baseboard so that the plastic enveloping material is melted and forms the package body, wherein the package body covers the outer surface of the electronic component, and the package body separates the electronic component and a sidewall of the recess.

According to the present disclosure, the outer surface of the electronic component is covered by the package body including the plastic enveloping material. The plastic enveloping material has several characters such as good heat dissipation capacity, low thermal expansion coefficient, high-temperature resistance, good bonding ability and high reliability. Thus, if the temperature of the electronic component rises when the electronic component functions, the package body may release heat rapidly. Furthermore, the package body may have good bonding force with the electronic component and the sidewall of the recess, and has a relatively low thermal expansion coefficient, which may solve the problem of fall-off and deformation of the electronic component to some extent.

### BRIEF DESCRIPTION OF THE DRAWINGS

In order to clearly explain the technical solutions in the embodiments of the present disclosure, the drawings used in the description of the embodiments will be briefly described below. Obviously, the drawings in the following description are merely some embodiments of the present disclosure. For those of ordinary skill in the art, other drawings may also be obtained based on these drawings without any creative work.
FIG. 1 is a schematic diagram of an embedded circuit board according to an embodiment of the present disclosure.
FIG. 2 illustrates a flow chart of a method for manufacturing an embedded circuit board according to an embodiment of the present disclosure.

### DETAILED DESCRIPTION

The disclosure will now be described in detail with reference to the accompanying drawings and examples. Apparently, the described embodiments are only a part of the embodiments of the present disclosure, not all of the embodiments. All other embodiments obtained by those skilled in the art based on the embodiments of the present invention without creative efforts shall fall within the protection scope of the present invention.

In the specification, terms such as "first" and "second" are used herein for purposes of description and are not intended to indicate or imply relative importance or significance. Thus, features limited by "first" and "second" are intended to indicate or imply including one or more than one these features. In the description of the present disclosure, "a plurality of' means two or more than two, unless specified otherwise.

All directional indications (such as up, down, left, right, front, rear, etc.) in the embodiments of the present application are only used to explain the relative positional relationship between the elements in a certain posture (as shown in the drawings), sports situations, etc. If the specific posture changes, the directionality indication also changes accordingly. Further, the terms "include" and "have" and any variants thereof are intended to cover non-exclusive inclusions. For example, a process, method, system, product, or device that comprises a series of steps or elements is not limited to the listed steps or elements, but may optionally include steps or elements that are not listed, or alternatively may include other steps or elements inherent these processes, methods, products, or devices.

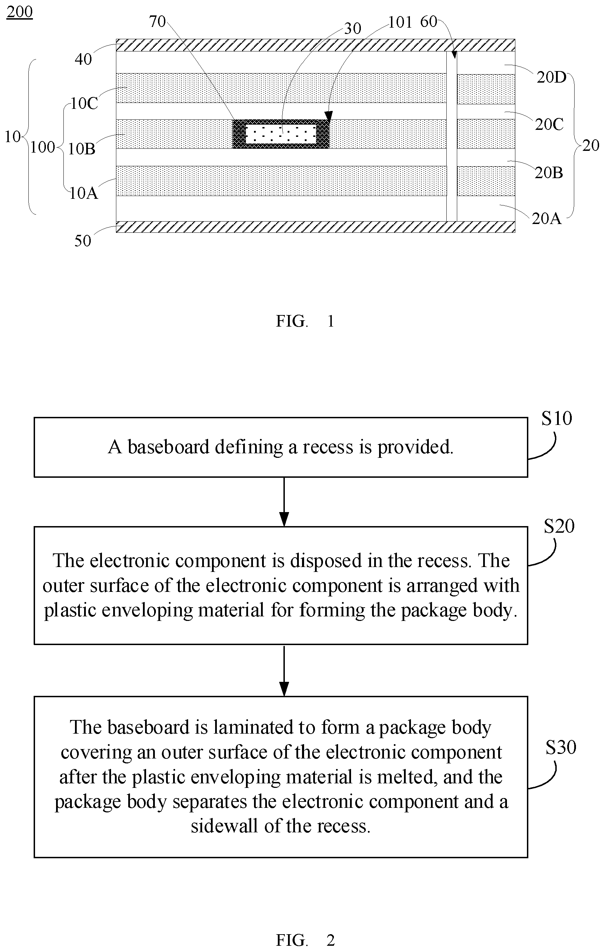

Referring to FIG. 1, an embedded circuit board 200 is provided according to an embodiment of the present disclosure. The embedded circuit board 200 may include: a baseboard 10, an electronic component 30 and a package body 70.

The baseboard 10 may define at least one recess 101. The electronic component 30 may be disposed in the corresponding recess 101. The package body 70 covers the outer surface of the electronic component 30 and separates the electronic component 30 and a sidewall of the recess 101. The package body 70 is made from a plastic enveloping material. The plastic enveloping material may include a base material and at least one of silicon dioxide, silicon carbide, silicon nitride and crystalline silicon powder.

In one embodiment, the plastic enveloping material may include a base material and an auxiliary material. The base material may include at least one of polyimide, epoxy resin, phenolic resin, curable polymer-based material and curable resin-based material. The auxiliary material may include at least one of silicon dioxide, silicon carbide, silicon nitride and crystalline silicon powder.

In some embodiments, the electronic component 30 is packaged. In other embodiments, the electronic component 30 is not packaged, that is, without metal base, plastic enveloping sealant or ceramic housing. The electronic component 30 may include at least one of chip, capacitor, resistance, power component and inductance component.

In some embodiments, the chip may be a MOS chip. The MOS chip may replace traditional high-power transistor and be placed in an amplifier circuit or a switch circuit, which may further be implemented widely in high-definition LCD plasma TVs.

The baseboard 10 defines a recess 101. The electronic component 30 is received in the recess 101. In some embodiments, the number of recesses 101 may be equal to the number of the electronic components 30. In this implementation, one recess 101 can be arranged with one electronic component 30. In other embodiments, the number of the recesses 101 may be different from the number of the electronic components 30. Specifically, the number of the recesses 101 may be less than the number of the electronic components 30. In this implementation, two or more electronic components 30 may be disposed in a same recess 101.

The recess 101 may be made by using depth-control milling. The depth-control milling is one milling technology which controls the processing depth in Z direction. The processing is limited by the milling precision in Z direction of the milling machine. The length and width of the recess 101 may be larger than the corresponding size of the chip to be embedded such that the recess 101 may be large enough to accommodate the chip to be embedded. The shape of the recess 101 may be rectangular, trapezoidal, or of step-configuration based on actual processing requirement, which is not limited herein. For illustrative purpose, the recess(s) 101 shown in the drawings has a rectangular configuration.

In some embodiments, material of the package body 70 may be a high heat dissipation material, magnetic material or low transmission loss material. When the package body 70 is made from the high heat dissipation material, the heat dissipation performance of the embedded circuit board 100 may be improved. When the package body 70 is made from the magnetic material, an electromagnetic shielding function may be achieved. When the package body 70 is made from the low transmission loss material, transmission of radio frequency signal and high frequency signal may be improved.

According to the present disclosure, the outer surface of the electronic component 30 is covered by the package body 70 including the plastic enveloping material. The plastic enveloping material has several characters such as thermosetting, good heat dissipation capacity, low thermal expansion coefficient, high-temperature resistance, good bonding ability and high reliability. Thus, the package 70 can withstand high temperature and has excellent heat dissipation capacity. If the temperature of the electronic component 30 rises when the electronic component 30 functions, the package body 70 may release heat rapidly. Furthermore, the package body 70 may have good bonding force with the electronic component 30 and the sidewall of the recess 101, and has a relatively low thermal expansion coefficient, which may solve the problem of fall-off and deformation of the electronic component to some extent.

In some embodiments, the plastic enveloping material may include a thermally conductive insulating auxiliary material. The thermally conductive insulating auxiliary material may be selected from the group of nano silicon nitride particles, nano boron nitride particles and so on.

In some embodiments, the package body 70 is arranged with a metal sheet (not shown). The metal sheet is disposed in the package body 70. One end of the metal sheet may be electrically connected to the electronic component 30, and another end may protrude from the package body 70 and be electrically connected to a grounding circuit layer, a signal circuit layer or a conductive hole so as to electrically connect the electronic component 30 and the circuit layer.

Specifically, the package body 70 may fill between the electronic component 30 and the sidewall of the recess 101, and seal the electronic component 30. The package body 70 may be arranged with a metal sheet, and the metal sheet may be utilized to electrically connect the electronic component 30 and the circuit layer or the conductive hole. The metal sheet may be made from pure metal including, but not limited to, copper, copper alloy, aluminum, aluminum alloy, iron, iron alloy, nickel, nickel alloy, gold, gold alloy, silver, silver alloy, platinum, platinum alloy, chromium, chromium alloy, magnesium, magnesium alloy, tungsten, tungsten alloy, molybdenum, molybdenum alloy, lead, lead alloy, tin, tin alloy, indium, indium alloy, zinc, or zinc alloy etc. In other embodiments, the material of the metal sheet may include metal base material and conductive graphite sheets. The heat resistance of conductive graphite sheets is less than that of normal metal and alloy, such that the heat conduction speed may be improved by embedding conductive graphite sheets in metal.

In other embodiments, the electronic component 30 may include a main body and a pin electrically connected to the main body. The main body may be located in the package body 70, and the pin may extend from the main body and out of the package body 70.

In one embodiment, the baseboard 10 may include a plurality of sub-layers 10A, 10B and 10C and a plurality of fusible medium layers 20A, 20B, 20C and 20D alternately arranged. At least one sub-layer 10B defines the recess 101 for receiving the electronic component 30. When the sub-layers 100 and the fusible medium layers 20 are laminated, at least some of the fusible medium layers 20 may enter between the package body 70 and the sidewall of the recess 101, and contact the package body 70.

Specifically, the sub-layers 10A, 10B and 10C and the fusible medium layers 20A, 20B, 20C and 20D may provide support in the entire embedded circuit board 200. The sub-layers 10A, 10B and 10C may be copper-free plates or copper-clad plates. A copper layer in the copper-clad plate may have good conductive performance, which is the most common material for printed circuits. By patterning each sub-layer 10, the required circuit pattern may be acquired, then the copper layer may be divided into a signal circuit layer and a grounding circuit layer based on a functional design. The pattern of the signal circuit layer is usually more complicated than that of the grounding circuit layer. Normally, the signal circuit layer may be a layer for forming multiple metal lines electrically connecting electronic components 30. The grounding circuit layer may be utilized to connect to the ground, and normally is a layer with large area of continuous metal regions.

In order to assure that the fusible medium layers 20 may completely fill the gaps between adjacent sub-layers 10 and to guarantee the entire strength of the embedded circuit board 200, the thickness of the fusible medium layer 20 may range from 60 to 300 um, specifically, the fusible medium layer 20 may be 60 um, 100 um, or 300 um.

In one embodiment, the thermal expansion coefficient of the package body 70 may be less than or equal to that of the sub-layer 10B embedded with the electronic component 30, and the thermal expansion coefficient of the package body 70 may be less than or equal to that of the electronic component 30. The thermal expansion coefficient of the package body 70 may range from 1 to 27 ppm/°C, such as 1 ppm/°C, 5 ppm/°C, 7 ppm/°C, 10 ppm/°C, 20 ppm/°C or 27 ppm/°C.

In some embodiments, the thermal expansion coefficient may be less than that of the sub-layer 10B embedded with the electronic component 30, and the thermal expansion coefficient of the package body 70 may be equal to that of the electronic component 30. The thermal expansion coefficient of the package body 70 may range from 3 to 17 ppm/°C, such as 1 ppm/°C, 5 ppm/°C, 7 ppm/°C, 10 ppm/°C, 13 ppm/°C or 17 ppm/°C.

Moreover, in order to guarantee that the package body 70 may entirely fill the space between the electronic component 30 and the recess 101 and to guarantee the entire strength of the embedded circuit board 200, the diameter of the package body 70 may range from 1 to 30 um, such as 1 um, 10 um, 20 um or 30 um.

According to the embedded circuit board 200 described in the above embodiment, the thermal expansion coefficient of the package body 70 is less than or equal to that of the sub-layer embedded with the electronic component 30. Since the package body 70 and the sub-layer embedded with the electronic component 30 have very close thermal expansion coefficients, the deformation of these two components due to temperature increase is also very close. Thus, obvious stress in the electronic component 30 due to different thermal expansion coefficients can be avoided, which may prevent the electronic component 30 from breaking or falling from the sub-layer.

In one embodiment, the fusible medium layer 20 may be made from resin or a plastic enveloping material.

Specifically, the resin refers to an organic polymer which may be softened or melted after being heated, may have flow tendency under external force when softening, and has a solid, semi-solid or liquid state (sometimes) in normal temperature. The resin may be epoxy resin, silicone resin, polyimide resin, phenolic resin, polyurethane, acrylic resin or other adhesive.

Moreover, the fusible medium layers 20A and 20D located at the most outside may be made from a high heat dissipation material, magnetic material or low transmission loss material. When the fusible medium layers 20A and 20D located at the most outside is made from the high heat dissipation material, the heat dissipation performance of the embedded circuit board 200 may be improved. When the fusible medium layers 20A and 20D located at the most outside is made from the magnetic material, electromagnetic shielding function may be achieved. When the fusible medium layers 20A and 20D located at the most outside is made from the low transmission loss material, transmission of radio frequency signal and high frequency signal may be improved.

In some embodiments, the material of the fusible medium layer 20 and the package body 70 may be the same. In other words, the fusible medium layer 20 and the package body 70 may both be plastic enveloping material, and the thermal expansion coefficients of the fusible medium layer 20 and the package body 70 may be the same.

Specifically, when the fusible medium layer 20 and the package body 70 both have a small thermal expansion coefficient, obvious stress in each sub-layer 10 due to thermal expansion and contraction of the fusible medium layer 20 may be avoided, which may prevent the sub-layers from deformation, and prevent the electronic component 30 from breaking or falling off. Thus, the circuit board 200 may keep presenting a flat state.

In one embodiment, the embedded circuit board 200 may further include a first circuit layer 40 and a second circuit layer 50. The first circuit layer 40 and the second circuit layer 50 may be disposed on two opposite sides of the baseboard 10 and cover two opposite sides of the recess 101. The electronic component 30 may be arranged with a connection terminal. The connection terminal of the electronic component 30 may electrically connect the first circuit layer and/or the second circuit layer. The connection terminal of the electronic component 30 may be electrically connected to the first circuit layer 40 and/or the second circuit layer 50 through the conductive hole 60, which is not limited thereto. Alternatively, the connection terminal may directly contact the first circuit layer 40 and/or the second circuit layer 50 to achieve electrical connection.

Specifically, the embedded circuit board 200 may define a through hole. In the present embodiment, the through hole penetrates through the sub-layers 10 and the fusible medium layers 20. A conductive layer for electrically connecting the sub-layer 10 and the signal circuit layer and/or the grounding circuit layer may be set inside the through hole to constitute the conductive hole 60. In the present disclosure, the through hole may be metalized by electroplating. Specifically, the metal of the through hole may be taken as a cathode and put in a solution with metal ion to be electroplated, and the conductive layer may be formed by depositing the positive ion of the metal to be electroplated in the solution on the metal surface of the through hole under electrolysis. Common metal for electroplating may include, but is not limited to, titanium, palladium, zinc, gold, brass, or bronze etc. In other embodiments, the metallization of the through hole may be realized by coating.

In some embodiments, one or more components (not shown) may be set on a side of the first circuit layer 40 away from the recess 101, or on a side of the second circuit layer 50 away from the baseboard 10. In other embodiments, a plurality of components may be arranged on a side of the first circuit board 40 away from the baseboard 10 and one side of the a circuit board 50 away from the baseboard 10 respectively. The components may be electrically connected to the electronic component 30 through the first circuit layer 40 and/or the second circuit layer 50. The components may include one or more of chip, capacitor, resistance and power device.

Referring to FIG. 2, a method for manufacturing an embedded circuit board is provided. The method may include the following operations.

At block S10: A baseboard defining at least one recess is provided.

In some embodiments, the baseboard is an insulating baseboard made from epoxy resin, polyimide, bismaleimide triazine, polyphenylene ether, polytetrafluoroethylene or phenylcyclobutene. In the present disclosure, the baseboard may be a prepreg baseboard. The baseboard can become adhesive in a certain condition (e.g., high temperature or high pressure), and can become completely solid after the process. The baseboard described in the present disclosure is completely solid baseboard transformed from a prepreg baseboard.

In another embodiment, the baseboard may be a printed circuit board, and the baseboard is formed by laminating in sequence a plurality of layers of copper-free plates or copper-clad plates and a plurality of fusible medium layers each located between two adjacent layers of copper-free plates or copper-clad plates.

The size of the recess may be determined based on the size of the electronic component to be received. Normally, the size of the recess may be larger than that of the electronic component. Specifically, the size of the recess in the thickness direction of the baseboard may be larger than that of the electronic component. Thus, the baseboard may protect the electronic component and reduce pressure applied to the electronic component in subsequent processes. The size of the recess in a direction perpendicular to the thickness direction of the baseboard may also be larger than the size of the electronic component such that the electronic component may be precisely received in the recess without being damaged.

At block S20: The electronic component is disposed in the recess. The outer surface of the electronic component is arranged with a plastic enveloping material for forming the package body. The plastic enveloping material may include a base material and at least one of silicon dioxide, silicon carbide, silicon nitride and crystalline silicon powder.

Specifically, the elastic enveloping material includes a base material and an auxiliary material. The base material may include at least one of polyimide, epoxy resin, phenolic resin, curable polymer-based material and curable resin-based material. The auxiliary material may include at least one of silicon dioxide, silicon carbide, silicon nitride and crystalline silicon powder .

At block S30: The baseboard is laminated to form a package body covering an outer surface of the electronic component after the plastic enveloping material is melted, and the package body separates the electronic component and a sidewall of the recess.

In the present embodiment, the plastic enveloping material is selected as a material of the package body. The plastic material (not processed) will be melted under high temperature and high pressure. The plastic enveloping material is filled in the recess, and the electronic component is located in the middle of the plastic enveloping material. When the baseboard and the plastic enveloping material is heated and pressurized, the plastic enveloping material can be meltled and cover the outer surface of the electronic component, and fill between the sidewall of the recess and the electronic component to form the package body.

In other embodiments, the plastic enveloping material may be melted and may cover the outer surface of the electronic component in advance. After cooling, a packaged electronic component may be acquired and then disposed in the recess. At last the baseboard is laminated, the package body fills between the electronic component and the sidewall of the recess after the package body is melted.

According to the present disclosure, the outer surface of the electronic component is covered by the package body including the plastic enveloping material. The plastic enveloping material has several characters such as good thermosetting, heat dissipation capacity, low thermal expansion coefficient, high-temperature resistance, good bonding ability and high reliability. Thus, the package 70 can withstand high temperature and has excellent heat dissipation capacity. If the temperature of the electronic component rises when the electronic component functions, the package body may release heat rapidly. Furthermore, the package body may have good bonding force with the electronic component and the sidewall of the recess, and has a relatively low thermal expansion coefficient, which may solve the problem of fall-off and deformation of the electronic component to some extent.

The embedded circuit board provided by the present disclosure may be implemented in mobile devices, vehicle devices, base station devices or sensing assembly.

The present disclosure further provides a mobile device including the embedded circuit board described in any of the foregoing embodiments.

The present disclosure further provides a vehicle device including the embedded circuit board described in any of the foregoing embodiments.

The present disclosure further provides a base station device including the embedded circuit board described in any of the foregoing embodiments.

The present disclosure further provides a sensing assembly including the embedded circuit board described in any of the foregoing embodiments.

The foregoing is merely embodiments of the present disclosure, and is not intended to limit the scope of the disclosure. Any transformation of equivalent structure or equivalent process which uses the specification and the accompanying drawings of the present disclosure, or directly or indirectly application in other related technical fields, are likewise included within the scope of the protection of the present disclosure.

## Claims

1. A method for manufacturing an embedded circuit board, comprising:
providing a baseboard defining at least one recess;
disposing an electronic component in the recess, wherein an outer surface of the electronic component is arranged with a plastic enveloping material for forming a package body, the plastic enveloping material comprises a base material and an auxiliary material, the base material comprises at least one of polyimide, epoxy resin, phenolic resin, curable polymer-based material and curable resin-based material, the auxiliary material comprises at least one of silicon dioxide, silicon carbide, silicon nitride and crystalline silicon powder; and
laminating the baseboard to form the package body after the plastic enveloping material is melted, wherein the package body covers the outer surface of the electronic component, and the package body separates the electronic component and a sidewall of the recess.

2. The method of claim 1, wherein the baseboard is an insulating baseboard made from epoxy resin, polyimide, bismaleimide triazine, polyphenylene ether, polytetrafluoroethylene or phenylcyclobutene.

3. The method of claim 1, wherein the baseboard is a printed circuit board, and the baseboard is formed by laminating in sequence a plurality of layers of copper-free plates or copper-clad plates and a plurality of fusible medium layers each located between two adjacent ones of the plurality of layers of copper-free plates or cooper-clad plates.

4. An embedded circuit board, comprising:
a baseboard defining a recess;
an electronic component disposed in the recess; and
a package body covering an outer surface of the electronic component to separate the electronic component and a sidewall of the recess, wherein the package body is made of a plastic enveloping material and the plastic enveloping material comprises a base material and at least one of silicon dioxide, silicon carbide, silicon nitride and crystalline silicon powder.

5. The embedded circuit board of claim 4, wherein the base material comprises at least one of polyimide, epoxy resin, phenolic resin, curable polymer-based material and curable resin-based material.

6. The embedded circuit board of claim 4, wherein the plastic enveloping material comprises thermally conductive insulating auxiliary material.

7. The embedded circuit board of claim 4, wherein the package body is arranged with a metal sheet, one end of the metal sheet is electrically connected to the electronic component and another end of the metal sheet protrudes from the package body to electrically connect the electronic component and a circuit layer.

8. The embedded circuit board of claim 4, wherein the baseboard comprises a plurality of sub-layers and a plurality of fusible medium layers alternately arranged, wherein at least one of the plurality of sub-layers defines the recess for receiving the electronic component;
when the plurality of sub-layers and the plurality of fusible medium layers are laminated, at least some of the plurality of fusible medium layers enter between the package body and the sidewall of the recess and contact the package body.

9. The embedded circuit board of claim 8, wherein a thermal expansion coefficient of the package body is less than a thermal expansion coefficient of one of the plurality of sub-layers embedded with the electronic component;
the thermal expansion coefficient of the package body is less than or equal to a thermal expansion coefficient of the electronic component, and
the thermal expansion coefficient of the package body ranges from 1 to 27 ppm/°C.

10. The embedded circuit board of claim 9, wherein the thermal expansion coefficient of the package body is less than a thermal expansion coefficient of the one of the plurality of sub-layers embedded with the electronic component;
the thermal expansion coefficient of the package body is equal to the thermal expansion coefficient of the electronic component, and
the thermal expansion coefficient of the package body ranges from 3 to 17 ppm/°C.

11. The embedded circuit board of claim 8, whereina material of the plurality of fusible medium layers comprises at lest one of resin and the plastic enveloping material.

12. The embedded circuit board of claim 11, wherein the plurality of fusible medium layers and the package body comprise a same material.

13. The embedded circuit board of claim 4, wherein the electronic component comprises at least one of chip, capacitor, resistance, power component and inductance component.

14. The embedded circuit board of claim 4, further comprising:
a first circuit layer and a second circuit layer disposed on two opposite sides of the baseboard and covering two opposite sides of the recess;
the electronic component is configured with a connection terminal electrically connected to at least one of the first circuit layer and the second circuit layer.

15. The embedded circuit board of claim 4, wherein the embedded circuit board is implemented in a mobile terminal, vehicle device, base station device or sensing assembly.

16. The method of claim 4, wherein the baseboard is an insulating board made from epoxy resin, polyimide, bismaleimide triazine, polyphenylene ether, polytetrafluoroethylene or phenylcyclobutene.

17. The method of claim 4, wherein the baseboard is a printed circuit board, and the baseboard is formed by laminating in sequence a plurality of layers of copper-free plates or copper-clad plates and a plurality of fusible medium layers each located between two adjacent ones of the plurality of layers of copper-free plates or cooper-clad plates.

18. A method for manufacturing an embedded circuit board, comprising:
providing a baseboard defining at least one recess;
disposing an electronic component in the recess, wherein an outer surface of the electronic component is arranged with a plastic enveloping material for forming a package body, the plastic enveloping material comprises a base material and at least one of silicon dioxide, silicon carbide, silicon nitride and crystalline silicon powder; and
laminating the baseboard so that the plastic enveloping material is melted and forms the package body, wherein the package body covers the outer surface of the electronic component, and the package body separates the electronic component and a sidewall of the recess.

19. The method of claim 18, wherein
the baseboard is an insulating baseboard made from epoxy resin, polyimide, bismaleimide triazine, polyphenylene ether, polytetrafluoroethylene or phenylcyclobutene.

20. The method of claim 18, wherein the baseboard is a printed circuit board, and the baseboard is formed by laminating in sequence a plurality of layers of copper-free plates or copper-clad plates and a plurality of fusible medium layers each located between two adjacent ones of the plurality layers of copper-free plates or cooper-clad plates.
